# EUROPÄISCHE PATENTSCHRIFT

(11) **EP 0 900 477 B1**
(45) Veröffentlichungstag und Bekanntmachung des Hinweises auf die Patenterteilung: **18.07.2001**
(21) Anmeldenummer: 97925867.0
(22) Anmeldetag: 23.05.1997
(51) Int. Cl.: H03H 9/05, H03H 9/10

(54) **ELEKTRONISCHES BAUELEMENT, INSBESONDERE MIT AKUSTISCHEN OBERFLÄCHENWELLEN ARBEITENDES BAUELEMENT - OFW-BAUELEMENT**
ELECTRONIC COMPONENT, IN PARTICULAR A COMPONENT USING ACOUSTICAL SURFACE ACOUSTIC WAVES
COMPOSANT ELECTRONIQUE, EN PARTICULIER COMPOSANT A ONDES ACOUSTIQUES DE SURFACE (COMPOSANT SAW)

(30) Priorität: 24.05.1996 DE 19621127
(43) Veröffentlichungstag der Anmeldung: 10.03.1999
(73) Patentinhaber: EPCOS AG, 81541 München (DE)
(72) Erfinder: STELZL, Alois, D-81549 München (DE); KRÜGER, Hans, D-81737 München (DE); PAHL, Wolfgang, D-80336 München (DE)
(74) Vertreter: Epping, Wilhelm, Dipl.-Ing.
(86) Internationale Anmeldenummer: DE9701055
(87) Internationale Veröffentlichungsnummer: WO9745955

(56) Entgegenhaltungen:
- EP-A- 0 472 856
- EP-A- 0 534 251
- EP-A- 0 637 871
- GB-A- 2 058 506

## Beschreibung

Die vorliegende Erfindung betrifft ein elektronisches Bauelement, insbesondere mit akustischen Oberflächenwellen arbeitendes Bauelement - OFW-Bauelement - nach dem Oberbegriff des Patentanspruchs 1.

Es ist bekannt, elektronische Bauelemente durch Schutzüberzüge gegen Umwelteinflüsse, wie beispielsweise Angriffe durch chemische Substanzen, etwa Feuchtigkeit zu schützen. So beschreibt beispielsweise die US-PS 3 438 873 den Schutz von Halbleiterbauelementen durch Schutzschichten aus Siliziumnitrid, Aluminiumoxid und gemischten Silikaten wie etwa Aluminiumsilikat. Dabei wird die Schutzschicht direkt auf das System des Halbleiterbauelementes aufgebracht. Unter Bauelementesystem wird dabei das die aktiven elektronischen Komponenten des Bauelementes enthaltende Substrat verstanden. Mit anderen Worten ausgedrückt, handelt es sich also bei dem Bauelementesystem um das Bauelement abgesehen von einem es enthaltenden Gehäuse.

Bei bestimmten elektronischen Bauelementen kann es unzweckmäßig und sogar für die Bauelementefunktion schädlich sein, eine Schutzschicht der vorgenannten Art auf das Bauelementesystem selbst aufzubringen. Dies ist beispielsweise bei mit akustischen Oberflächenwellen arbeitenden Bauelementen der Fall, da eine auf das Bauelementesystem derartiger Bauelemente aufgebrachte Schutzschicht die Ausbreitung von akustischen Oberflächenwellen beeinträchtigen kann. Ein weiteres Beispiel dafür wären Sensoren für mechanische Spannungen, da durch die Schutzschicht im Sensorsystem hervorgerufene mechanische Verspannungen die Detektierung von zu messenden mechanischen Spannungen beeinflussen können.

Aus der EP 06 37 871 A ist ein Oberflächenwellenbauelement bekannt, welches in Flip-Chip-Technologie auf einer Substratplatte befestigt ist. Das Bauelement ist mit einer metallischen, auf der Basisplatte aufsitzenden Schutzkappe abgedeckt.

Aus der GB 2 05 8506 A ist ein elektrisches Bauelement bekannt, welches auf einer Basisplatte montiert und mittels Bonddrähten kontaktiert ist. Das Bauelement ist mit einer metallischen, auf der Basisplatte aufsitzenden Schutzkappe abgedeckt.

Der vorliegenden Erfindung liegt die Aufgabe zugrunde, eine Möglichkeit zum Schutz von elektronischen Bauelementen gegen Umwelteinflüsse ohne die Beeinträchtigungen anzugeben, wie sie durch auf Bauelementesysteme aufgebrachte Schutzschichten entstehen können.

Diese Aufgabe wird bei einem elektronischen Bauelement der eingangs genannten Art erfindungsgemäß durch die Merkmale des kennzeichnenden Teils des Patentanspruchs 1 gelöst.

Weiterbildungen der Erfindung sind Gegenstand von Unteransprüchen.

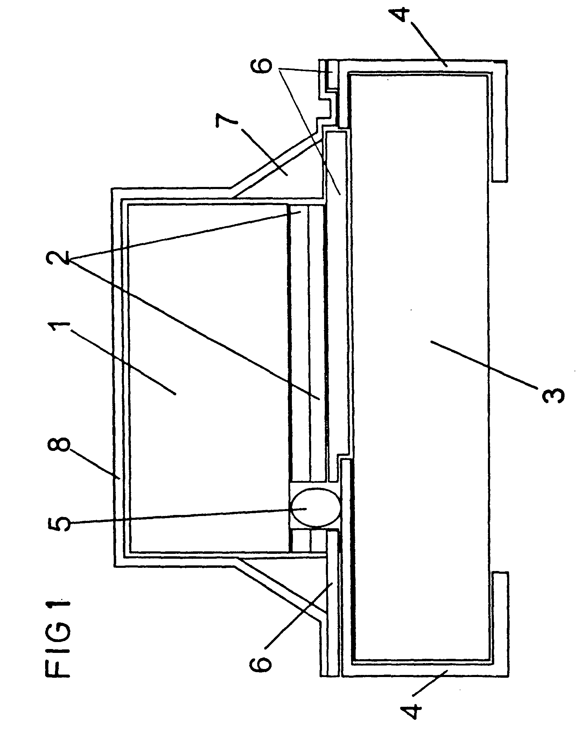

Die Erfindung wird nachfolgend anhand von in den Figuren der Zeichnungen dargestellten Ausführungsbeispiele näher erläutert. Dabei zeigen die Figuren 1 bis 3 schematisch verschiedene Ausführungsformen von erfindungsgemäß ausgebildeten elektronischen Bauelementen.

Bei der Ausführungsform eines elektronischen Bauelementes nach Figur 1 ist ein Bauelementesystem elektrisch kontaktiert auf einer Basisplatte 3 montiert. Das Bauelementesystem ist schematisch durch ein Substrat 1 und einen nicht dargestellte elektrisch leitende Strukturen umgebenden isolierenden Rahmen 2 dargestellt. Bei den elektrisch leitenden Strukturen kann es sich für OFW-Bauelemente beispielsweise um Interdigitalwandler, Resonatoren oder Reflektoren handeln.

Unter "Basisplatte" wird im Rahmen vorliegender Erfindung jedes leiterbahnentragende Substrat sowohl auf Kunststoff-, Glas- oder Keramikbasis verstanden. Auf der Basisplatte 3 sind Leiterbahnen 4 vorgesehen, die über Bumps 5 mit den (nicht dargestellten) leitenden Strukturen auf dem Substrat 1 des Bauelementesystems kontaktiert sind. Bei einer derartigen elektrischen Kontaktierung handelt es sich um die an sich bekannte sogenannte Flip-Chip-Montage.

Zwischen dem die elektrisch leitenden Strukturen auf dem Substrat 1 umgebenden Rahmen 2 sowie den Leiterbahnen 4 auf der Basisplatte 3 ist eine Isolierschicht 6 vorgesehen, die z. B. aus Epoxidharz oder Glas besteht. Schließlich ist im Verbindungsbereich zwischen dem Bauelementesystem 1, 2 und der Basisplatte 3 eine Umrahmung 7 vorgesehen, bei der es sich beispielsweise um einen Klebstoff, ein Gießharz oder eine Pressmasse handeln kann. Diese Umrandung ist insbesondere deshalb vorgesehen, um Scherkräfte aufzunehmen, die durch unterschiedliche thermische Ausdehnungen von Bauelementesystem und Basisplatte zustande kommen und die elektrische Kontaktierung zwischen elektrisch leitenden Strukturen auf dem Substrat 1 und den Leiterbahnen 4 auf der Basisplatte 3 über die Bumps 5 mechanisch beeinträchtigen könnten.

Erfindungsgemäß ist auf der Bauelementeseite, die dem Verbindungsbereich zwischen Bauelementesystem 1, 2 und Basisplatte 3 abgewandt ist, eine Schutzschicht 8 vorgesehen, welche einen gegen Umwelteinflüsse dichten Verschluß für das Bauelementesystem zur Basisplatte hin bildet. Wie nachfolgend noch genauer erläutert wird, kann diese Schutzschicht 8 auf verschiedene Weise ausgebildet sein.

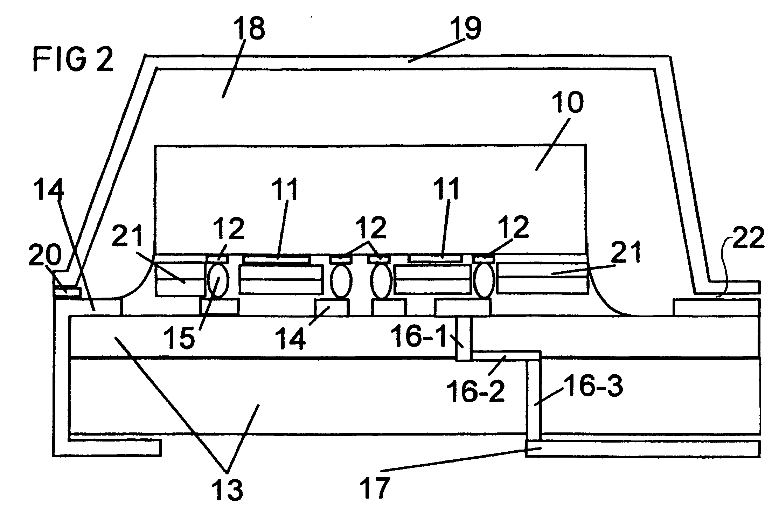

Bei der Ausführungsform eines OFW-Bauelementes nach Figur 2 wird ein OFW-Bauelementesystem durch ein piezoelektrisches Substrat 10 sowie auf diesem vorgesehene leitende Strukturen 11 und Anschlußflächen 12 - Pads - für die leitenden Strukturen 11 gebildet. Bei den elektrisch leitenden Strukturen 11 kann es sich beispielsweise wiederum um Interdigitalwandler, Resonatoren oder Reflektoren handeln. Die leitenden Strukturen 11 und die Pads 12 sind entsprechend der Ausführungsform nach Figur 1 von einem isolierenden Rahmen 21 umgeben. Die Darstellung eines OFW-Bauelementesystems 10, 11, 12 nach Figur 2 ist wiederum lediglich schematischer Natur. Ein vollständiger Aufbau eines derartigen Bauelementesystems für OFW-Bauelemente ist an sich bekannt und wird daher hier nicht näher erläutert.

Weiterhin ist eine Basisplatte 13 vorgesehen, auf deren dem Bauelementesystem 10, 11, 12 zugekehrten Seite Leiterbahnen 14 mit darauf befindlichen Bumps 15 vorgesehen, über die eine elektrische Kontaktierung des Bauelementes an den Pads 12 erfolgt. Die Ausbildung der Basisplatte 13 ist nicht auf eine Zweilagigkeit beschränkt. Es sind auch Basisplatten mit mehr als zwei Lagen verwendbar.

Die elektrischen Kontaktierungen können dadurch aus dem Bauelement herausgeführt werden, daß die Leiterbahnen 14 um die Basisplatte 13 herumgeführt sind, wie dies auf der linken Seite von Figur 2 dargestellt ist, oder durch die Basisplatte über Durchführungen 16-1, 16-2, 16-3 mit Leiterbahnen 17 auf der Außenseite der Basisplatte 13 verbunden sind. Die in Vertikalrichtung versetzte Ausgestaltung der elektrischen Durchführung 16-1, 16-2, 16-3 dient dazu, einen Eintritt von die Bauelementefunktion beeinträchtigenden chemischen Substanzen zu verhindern, d. h. durch die versetzte Ausbildung der Durchführung ist eine Gasdichtigkeit von der Außenseite der Basisplatte 13 her gewährleistet. Wenn die Leiterbahnen 14 um die Basisplatte 13 herumgeführt und mit einem Pad 12 über Bumps 15 verbunden sind, ist zwischen Leiterbahn 14 und einer nachfolgend beschriebenen Schutzschicht 19 eine Isolierschicht 20 erforderlich.

Das Bauelementesystem 10, 11, 12 ist auf der Basisplatte 13 durch eine Kunststoffumhüllung 18 abgedeckt. Diese Abdeckung 18 kann durch Gießharze, Pressmassen oder Thermoplaste gebildet werden.

Auf der Abdeckung 18 ist erfindungsgemäß auf der dem Verbindungsbereich zwischen Bauelementesystem 10, 11, 12 und Basisplatte 13 abgewandten Seite eine erfindungsgemäße Schutzschicht 19 vorgesehen, die einen gegen Umwelteinflüsse dichten Verschluß zur Basisplatte 13 hin bildet.

Wie oben bereits ausgeführt, kann die Schutzschicht 8 nach Figur 1 bzw. 19 nach Figur 2 auf verschiedene Weise ausgebildet sein. Sie kann gemäß einer Ausführungsform eine Metall enthaltende Schicht oder eine Vollmetallschicht sein. Weiterhin kann sie (in den Figuren 1 und 2 nicht eigens dargestellt) auch durch mehrere Teilschichten gebildet sein, von denen mindestens eine eine Metallschicht ist. Weiterhin kann eine der Teilschichten eine Glasschicht sein, bei der es sich insbesondere um die untere Teilschicht einer Teilschichtfolge handelt. Als Metalle kommen beispielsweise Kupfer, Nickel oder Gold in Frage. Eine Metallschicht kann beispielsweise durch Aufdampfen, Vakuummetallisierung, Galvanik oder Laminieren aufgebracht werden. Gggf. kann dabei auf der Metallschicht eine nicht eigens dargestellte Korrosionsschutzschicht vorgesehen sein. Weiterhin kann unter der Metallschicht eine ebenfalls nicht dargestellte Haftschicht vorgesehen sein.

Wie anhand der Ausführungsform nach Figur 2 dargestellt, kann die Schutzschicht 19, d. h. speziell deren metallischer Teil elektrisch kontaktiert sein, so daß die Schutzschicht 19 nicht nur eine gegen Umwelteinflüsse schützende Schicht ist sondern gleichzeitig auch eine Hochfrequenzabschirmung für das Bauelementesystem 10, 11, 12 bildet. Zu diesem Zweck ist die Schutzschicht 19 mit einer Leiterbahn 14 auf der Basisplatte 13 verbunden, wie dies in Figur 2 durch eine Verbindung 22 dargestellt ist.

## Patentansprüche

1. Elektronisches Bauelement, insbesondere mit akustischen Oberflächenwellen arbeitendes Bauelement - OFW-Bauelement -,
bei dem ein elektrisch leitende Strukturen (11, 12) auf einem Substrat (1; 10) umfassendes Bauelementesystem (1, 2; 10, 11, 12) elektrisch kontaktiert und in Flip-Chip-Technik auf einer Basisplatte (3; 13) montiert ist,
bei dem eine Schutzschicht direkt (8) auf die dem Verbindungsbereich zwischen Bauelementesystem (1, 2) und Basisplatte (3) abgewandte Seite des Substrats (1) bis hin zur Basisplatte (3) so aufgebracht ist, daß ein gegen Umwelteinflüsse dichter Verschluß zur Basisplatte (3) hin besteht, bei dem die Schutzschicht eine Metallschicht ist oder eine Teilschicht aus Metall umfaßt.

2. Bauelement nach Anspruch 1,
bei dem die Schutzschicht (8; 19) eine aus mehreren Teilschichten gebildete Schicht ist.

3. Bauelement nach Anspruch 2,
bei dem mindestens eine Teilschicht eine Glasschicht ist.

4. Bauelement nach Anspruch 3,
bei dem die Glasschicht die untere Teilschicht einer Teilschichtfolge ist.

5. Bauelement nach einem der Ansprüche 1 bis 4,
bei dem auf der Schutzschicht (8; 19) eine Korrosionsschutzschicht vorgesehen ist.

6. Bauelement nach einem der Ansprüche 1 bis 5,
bei dem unter der Schutzschicht (8; 19) eine Haftschicht vorgesehen ist.

7. Bauelement nach einem der Ansprüche 1 bis 6,
bei dem der metallische Teil der Schutzschicht (8; 19) elektrisch kontaktiert ist.

8. Bauelement nach einem der vorangehenden Ansprüche,
bei dem die Metallschicht oder die Teilschicht aus Metall für die Schutzschicht durch Aufdampfen, Vakuummetallisierung, Galvanik oder Laminieren aufgebracht ist.

9. Bauelement nach einem der vorangehenden Ansprüche,
bei dem die Metallschicht (8) eines der Metalle Kupfer, Nikkel oder Gold umfaßt.

## Claims

1. Electronic component, in particular a component operating with surface acoustic waves - SAW component -,
in which a component system (1, 2; 10, 11, 12) which comprises electrically conductive structures (11, 12) on a substrate (1; 10) is mounted in a manner such that it makes electrical contact and using flip-chip technology on a baseplate (3; 13),
in which a protective layer (8) is applied, towards the baseplate (3), directly to that side of the substrate (1) which faces away from the connecting region between the component system (1, 2) and the baseplate (3), such that a seal which is proof against environmental influences is formed toward the baseplate (3), and in which the protective layer is a metal layer or comprises a partial layer made of metal.

2. Component according to Claim 1,
in which the protective layer (8; 19) is a layer formed from a plurality of partial layers.

3. Component according to Claim 2,
in which at least one partial layer is a glass layer.

4. Component according to Claim 3,
in which the glass layer is the lower partial layer of a partial layer sequence.

5. Component according to one of Claims 1 to 4,
in which an anti-corrosion layer is provided on the protective layer (8; 19).

6. Component according to one of Claims 1 to 5,
in which an adhesion layer is provided under the protective layer (8; 19).

7. Component according to one of Claims 1 to 6,
in which electrical contact is made with the metallic part of the protective layer (8; 19).

8. Component according to one of the preceding claims,
in which the metal layer or the partial layer made of metal for the protective layer is applied by vapour deposition, vacuum metallization, electrodeposition or lamination.

9. Component according to one of the preceding claims,
in which the metal layer (8) comprises one of the metals copper, nickel or gold.

## Revendications

1. Composant électronique, notamment composant travaillant par des ondes acoustiques de surface - composant OS - dans lequel un système (1, 2 ; 10, 11, 12) de composants comportant des structures (11, 12) conductrices de l'électricité sur un substrat (1 ; 10) est mis en contact électrique et est monté en technique Flip-Chip sur une plaquette (3 ; 13) de base,
dans lequel une couche (8) protectrice est déposée directement sur le côté du substrat (1) éloigné de la zone de liaison entre le système (1, 2) de composants et la plaquette (3) de base jusqu'à la plaquette (3) de base de telle manière qu'il existe une fermeture étanche aux influences extérieures en' direction de la plaquette (3) de base, la couche protectrice étant une couche métallique ou comportant une sous-couche en métal.

2. Composant suivant la revendication 1, dans lequel la couche (8 ; 19) protectrice est une couche formée de plusieurs strates.

3. Composant suivant la revendication 2, dans lequel au moins une strate est une couche de verre.

4. Composant suivant la revendication 3, dans lequel la couche de verre est la strate inférieure d'une succession de strates.

5. Composant suivant l'une des revendications 1 à 4, dans lequel il est prévu sur la couche (8 ; 19) protectrice une couche de protection vis à vis de la corrosion.

6. Composant suivant l'une des revendications 1 à 5, dans lequel il est prévu une couche adhésive en-dessous de la couche (8 ; 19) protectrice.

7. Composant suivant l'une des revendications 1 à 6, dans lequel la couche métallique de la couche (8 ; 19) protectrice est mise en contact électrique.

8. Composant suivant l'une des revendications précédentes, dans lequel la couche métallique ou la strate en métal pour la couche protectrice sont déposées par dépôt en phase vapeur, métallisation sous vide, placage électrolytique ou laminage.

9. Composant suivant l'une des revendications précédentes, dans lequel la couche (8) métallique comporte l'un des métaux cuivre, nickel ou or.
